Europäisches Patentamt

European Patent Office

Office européen des brevets

(19)

(11) Publication number: **0 245 040**
**A2**

(12) **EUROPEAN PATENT APPLICATION**

(21) Application number: **87303907.7**

(22) Date of filing: **30.04.87**

(51) Int. Cl.⁴: **H 03 J 7/32, H 03 J 7/18**

(30) Priority: **09.05.86 GB 8611373**

(43) Date of publication of application: **11.11.87**
**Bulletin 87/46**

(84) Designated Contracting States: **DE FR GB IT NL**

(71) Applicant: **SIGNAL PROCESSORS LIMITED, Cambridge Science Park Milton Road, Cambridge CB4 4GJ (GB)**

(72) Inventor: **Barton, Stephen Kingsley, 5 Pieces Lane, Waterbeach Cambridge CB 5 9NF (GB)**
Inventor: **Aspin, Gordon James, 17 High Ditch Road, Fen Ditton Cambridge CB 5 8TE (GB)**

(74) Representative: **Beresford, Keith Denis Lewis et al, BERESFORD & Co. 2-5 Warwick Court High Holborn, London WC1R 5DJ (GB)**

(54) **Radio beacon receiving method and apparatus.**

(57) The receiver comprises a bank of filters (6) and detectors (8), the filters being responsive to overlapping frequency ranges. A comparator (10) responds to the detector producing the output of greatest magnitude to control the frequency of a local oscillator (4) so as to maintain the frequency of an input signal down-converted by a frequency changer (2) within a predetermined one of the frequency ranges of the filters.

EP 0 245 040 A2

- 1 -

# RADIO BEACON RECEIVING METHOD AND APPARATUS

This invention relates to a method and apparatus for receiving and measuring the signal strength of radio beacon signals. It is particularly applicable to the reception of satellite propagation beacons, where the signal to noise ratio may be very low.

As is well known, statistics of the atmospheric attennuation imposed on a radio signal may be collected by measuring the received strength of an un-modulated carrier wave (CW) signal. Alternatively, the signal may be modulated by a pre-determined waveform which is known to the receiver. The receiver can then remove this modulation, converting the signal to CW. Tracking of the direction of arrival of the signal may be achieved by further processing of the signal strength information, in conjunction with an antenna pointing controller. In this case, use is often made of telemetry beacon with unknown data, but which has a residual carrier signal.

The dynamic range of such a beacon receiver is limited by the signal to noise ratio. Since additive thermal noise is "white", i.e. its energy is equally

- 2 -

distributed over all frequencies, the signal to noise ratio may be increased by reducing the bandwidth of the receiver. If the signal had zero bandwidth the signal to noise ratio could be made arbitrarily large.

Unfortunately, it is not possible to generate a truly zero-bandwidth signal. Noise in the circuits of the frequency source produces "phase noise" at the output, which spreads the energy over a narrow band of frequencies. This leads to a minimum receiver bandwidth requirement. Conventional beacon receivers use phase locked loop (PLL) techniques to track the long term drift of the carrier frequency. The use of phase information leads to an unnecessarily large bandwidth in such receivers.

According to the present invention, there is provided radio beacon receiving apparatus in which a frequency changer receives a carrier frequency signal and a local oscillator signal to produce a down converted carrier frequency signal which is applied to a bank of at least three filters and detectors responsive to overlapping frequency ranges, and in which a comparator responds to the detector producing the output of greatest magnitude to control the frequency

- 3 -

of the local oscillator signal so as to maintain the frequency of the down converted signal within a predetermined one of the frequency ranges.

The invention is described further by way of example with reference to the accompanying drawings, in which:

Figure 1 is a functional block diagram of a beacon receiver incorporating an embodiment of the invention, and

Figure 2 is a frequency spectrum diagram of the system of fig. 1.

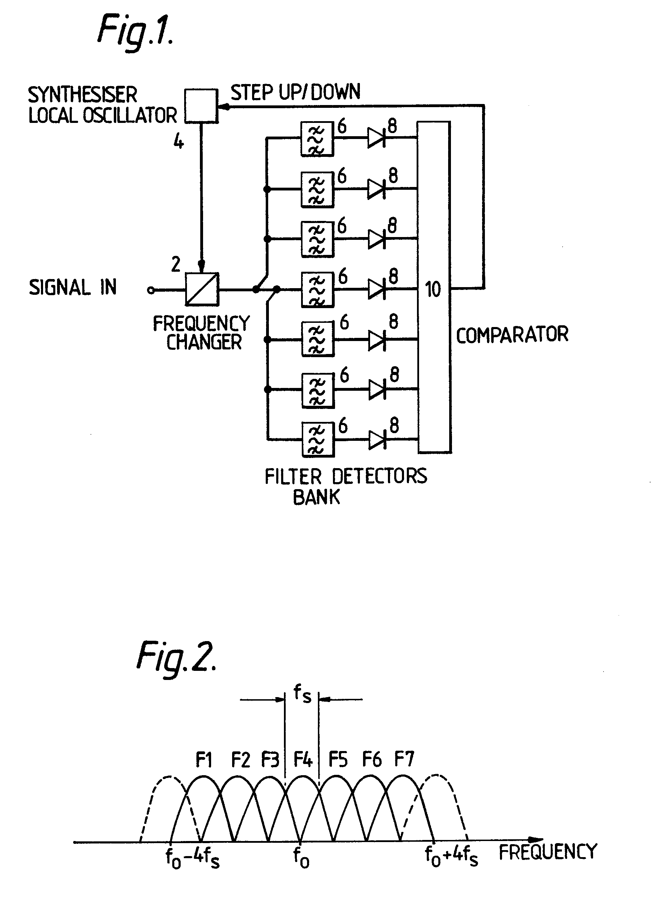

With reference to figure 1, the incoming signal is first down-converted in the frequency changer (2) to a suitable low frequency for processing. The output from this is passed to the bank of filters (6) and detectors (8). In this example seven filters are shwon, but the exact number is not important. Figure 2 shows the frequency responses of the seven filters as F1 to F7. The filters may be implemented as analogue band pass filters or frequency down-converters and low pass filters. In practice, it is convenient to implement them digitally using

- 4 -

the Discrete Fourier Transform (DFT) or the Fast Fourier Transform (FFT).

Any signal frequency in the range $f_o - 4f_s$ to $f_o + 4f_s$ will produce a response in at least one filter, and generally also a second one. Here $f_o$ is the centre frequency of the central filter (F4) and $f_s$ is the filter bandwidth to the cross-over points. The detector outputs are passed to the comparator (10) which decides which is the largest. If the output from filter F4 is not the strongest, the comparator instructs the synthesiser local oscillator (4) to step up or down in frequency by $f_s$. The synthesiser step size is chosen, for this example, to be the same as the filter bandwidth to the cross-over points.

Under high signal to noise ratio conditions the filter in which the signal falls will have the largest output with very high probability. As the frequency drifts from the central filter band to the one on either side the system reacts immediately by stepping the synthesiser. The signal, therefore, never appears in the outer bands. The output from these filters can thus be used as a measure of the background noise level for estimation of the signal to noise ratio. At low signal to noise ratios the

- 5 -

probability of a noise induced output from one of the outer bands exceeding the signal output becomes significant. This is indicated by the outputs from all seven filters being at a similar level. When this condition is detected the synthesiser frequency is not stepped, but frozen in anticipation that the signal level will soon recover, and that the frequency will be within +/- 4fs of its previous value. If the signal does not reappear within a pre-determined time, a search is initiated.

The search may be implemented, for example, by stepping the synthesiser frequency in steps of 8fs. The frequency is allowed to "dwell" for a period on each step to establish whether the signal has been found. The frequency is stepped up and down over a slowly expanding frequency range until the signal is found. This may also be the procedure on switch-on for initial acquisition of the signal.

An embodiment of the present invention as described hereinbefore enables the receiver noise bandwidth to be reduced by at least a factor of 20 compared to PLL systems, by using only power and frequency information. This extends the dynamic range by at least 13 dB.

0245040

- 6 -

A preferred embodiment of the invention provides a method and apparatus for tracking the long term drift of beacon signal frequency, without the dynamic range limitations inherent in the PLL. It therefore makes signal strength measurements possible at very low signal to noise ratios.

- 7 -

CLAIMS:

1. Radio beacon receiving apparatus characterised in that a frequency changer (2) receives a carrier frequency signal and a local oscillator signal to produce a down converted carrier frequency signal which is applied to a bank of at least three filters (6) and detectors (8) responsive to overlapping frequency ranges, and in which a comparator (10) responds to the detector (8) producing the output of greatest magnitude to control the frequency of the local oscillator signal so as to maintain the frequency of the down converted signal within a predetermined one of the frequency ranges.

2. Apparatus according to claim 1, wherein said bank of filters (6) and detectors (8) is implemented digitally by means of a Discrete Fourier Transform or a Fast Fourier Transform.

3. Apparatus according to claim 1, 2 or 3 wherein the comparator (10) instructs the local oscillator (4) to change frequency in steps corresponding to the frequency band widths of the filters (6) to maintain the frequency of the down-converted signal within the predetermined one of the frequency ranges.

- 8 -

4.   Apparatus according to claim 3 wherein the frequency of the local oscillator (4) signal is maintained constant when the outputs of the detectors are all at a similar level.

5.   Apparatus according to claim 1, 2, 3 or 4 wherein the local oscillator (4) is a frequency synthesizer.

Fig.1.

SYNTHESISER
LOCAL OSCILLATOR

STEP UP/DOWN

4

2

SIGNAL IN

FREQUENCY
CHANGER

6  8
6  8
6  8
6  8
6  8
6  8
6  8

10

COMPARATOR

FILTER DETECTORS
BANK

Fig.2.

$f_s$

F1  F2  F3  F4  F5  F6  F7

$f_0-4f_s$          $f_0$          $f_0+4f_s$          FREQUENCY